# EUROPEAN PATENT SPECIFICATION

(11) **EP 0 312 975 B1**
(45) Date of publication and mention of the grant of the patent: **15.04.1998**
(21) Application number: 88117298.5
(22) Date of filing: 18.10.1988
(51) Int. Cl.: H01L 23/538, H01L 23/50, H01L 23/52

(54) **Semiconductor chip package**
Halbleiterchippackung
Empaquetage pour puce semi-conductrice

(30) Priority: 23.10.1987 US 112851
(43) Date of publication of application: 26.04.1989
(73) Proprietor: SAMSUNG ELECTRONICS CO., LTD., Chung-Ku, Seoul 100-742 (KR)
(72) Inventor: Spielberger, Richard K., Maple Grove Minnesota 55369 (US); Dunaway, Thomas J., St. Louis Park Minnesota 55416 (US)
(74) Representative: Tunstall, Christopher Stephen

(56) References cited:
- EP-A- 0 171 783
- US-A- 4 245 273
- SOLID STATE TECHNOLOGY, vol. 27, no. 1, January 1984, pages 119-122, Port Washington, New York, US; A.H. MONES et al.: "Interconnecting and packaging VLSI chips"

## Description

A semiconductor chip package comprising the features listed in the preamble of claim 1 is described in US-A 4 551 746. The semiconductor chip is located within a cavity formed by several layers of the chip package, whereas the bottom layer is provided with a plurality of contact extensions made of tungsten material. The electrically conducting layers and leads of the various layers are connected together by means of metal plated castellations provided at the periphery of the package. Radially extending traces constituting spaced electro-plated signal leads extend from the wall surrounding the cavity to said castellations. They are provided at one of the various layers, and the connections between those radial traces and the contact pads of the semiconductor chip are made by bond wires.

In a second embodiment of this known chip package a first metalized large area layer forms a power plane, and its second metalized layer constitutes a ground potential plane. A third metal layer functions as a second power plane.

When a semiconductor chip is designed, it is quite common to find that there is no package available which is compatible with the chip for the purpose of interfacing the chip to a next level of packaging, e.g., to a printed circuit board. Accordingly, there are literally thousands of single-purpose semiconductor chip packages available; even in a 40 pin design, there are likely 60-80 variations available.

Fabricating specialized packages for each new chip design becomes expensive, particularly for chip designs having 200 to 300 pads, each requiring connection to the package for signal, power, or ground. Unless the chip is properly designed for a pre-existing package, connection by way of wire bonds or thermally activated bonding (TAB) connections cannot be made; in other words, if the chip has not been laid out so that direct connections from the edges of a chip can be made to corresponding signal, power or ground pads on the chip package, a special package must be designed and fabricated, resulting in present-day costs of $30,000 to $80,000 per chip package, typically $45,000 for a sophisticated package.

A significant problem with making the pads located on semiconductor chip packages available for handling either signal, power or ground is that special design considerations must be adhered to for power or ground paths that do not apply to signal paths. It is not uncommon in semiconductor chip packages for signal leads within the package to have relatively high resistance and inductance values, e.g., a total resistance on the order of 1 ohm and an inductance on the order of 2 nanohenries/cm; such signal path values are normally acceptable to the designers of most chips. On the other hand, most chip designers would like a relatively low resistance and inductance path between power and ground pads and corresponding next-level-of-packaging power or ground connectors. For example, many semiconductor chip package specifications require a resistance value of less than 0.1 ohm, and an inductance value in the picohenry range for power or ground paths is frequently desirable. Accordingly, it is normally not acceptable to simply use the electrical paths available through what are originally designed to be signal paths within a chip package for power or ground connections.

These problems are solved by a semiconductor chip package comprising the present invention, which permits individual pads on the package to function either as signal, power or ground; in addition, this selectivity is accomplished in the preferred embodiment while attaining a typical power and ground path having a resistance of less than 100 milliohms, typically 35-50 milliohms, and having an inductance of less than one nanohenry. The invention is characterized in the independent claim. Preferred details are described in the dependent claims.

The present invention is a semiconductor chip package comprising:
a) a plurality of connector pads (26) located on a first surface of the package and arranged about the periphery of a semi-conductor chip (24), each pad being adapted for interconnection with the semiconductor chip;
b) a plurality of electrical connectors (22) located on a second surface of the package, some of the electrical connectors (22) being dedicated power or ground connectors (22) and others being signal connectors.
c) a plurality of signal connection means (28, 30) providing an electrically conductive path between an individual connector pad (26) and a corresponding individual signal connector (22); and
d) a plurality of electrical connection means (28, 32 to 48) comprising conductive paths for selectively connecting any connector pad (26) to one of the power or ground connectors; the electrical connection means comprising at least two large area conductor areas (32 to 40).
characterised in that:
e) at least two large area conductor areas (34 to 40) are ring-shaped, provided on or beneath the first surface and, in plan view, are arranged around the contour of the semiconductor chip (24) and surround the connector pads (26).

The invention will now be explained by reference to embodiments shown in the drawings, in which
Figure 1 illustrates the top layer of one preferred embodiment of the present invention.
Figure 1A illustrates a typical cross sectional view of a semiconductor chip package comprising the present invention.
Figures 4-12 illustrate layers 4-12 of one preferred embodiment of the present invention.
Figure 13 illustrates the top layer of another preferred embodiment of the present invention.

### Detailed Description of the Preferred Embodiments

The semiconductor chip package disclosed here is a 269 pin grid array package. However, the concept of the present invention is applicable to other lead count packages as well to packages of designs other than pin grid arrays; for example, the present invention applies equally well to chip carriers.

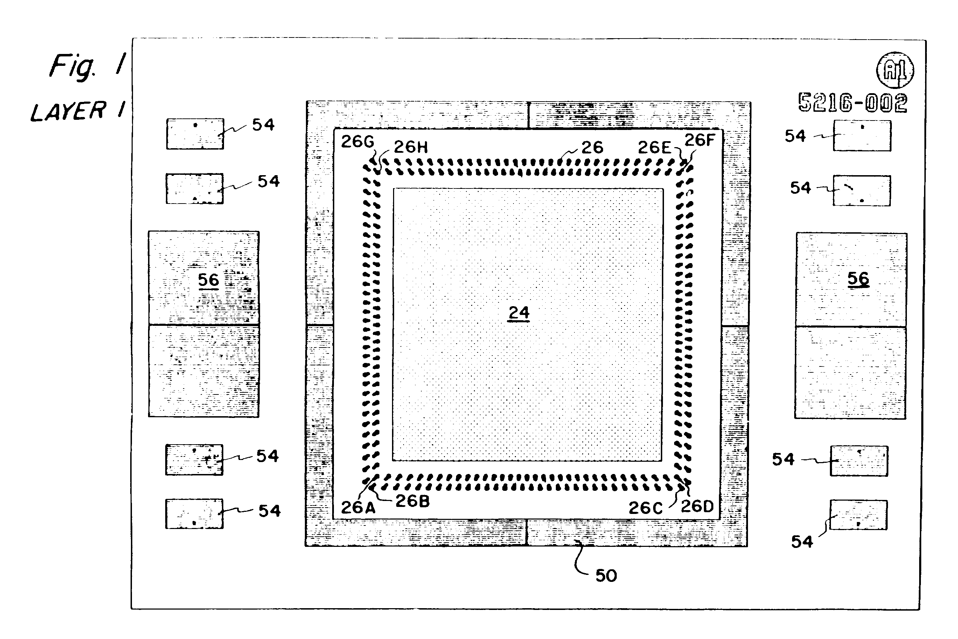

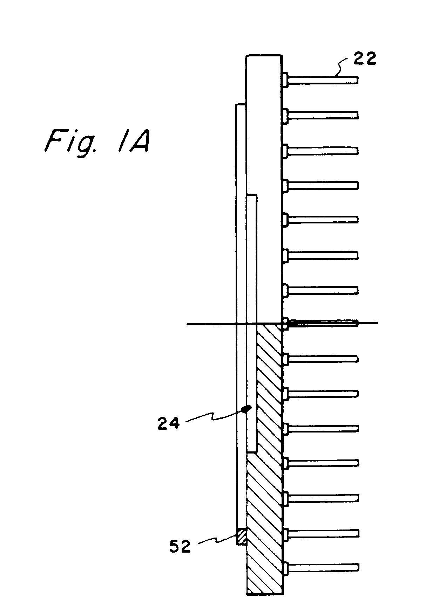

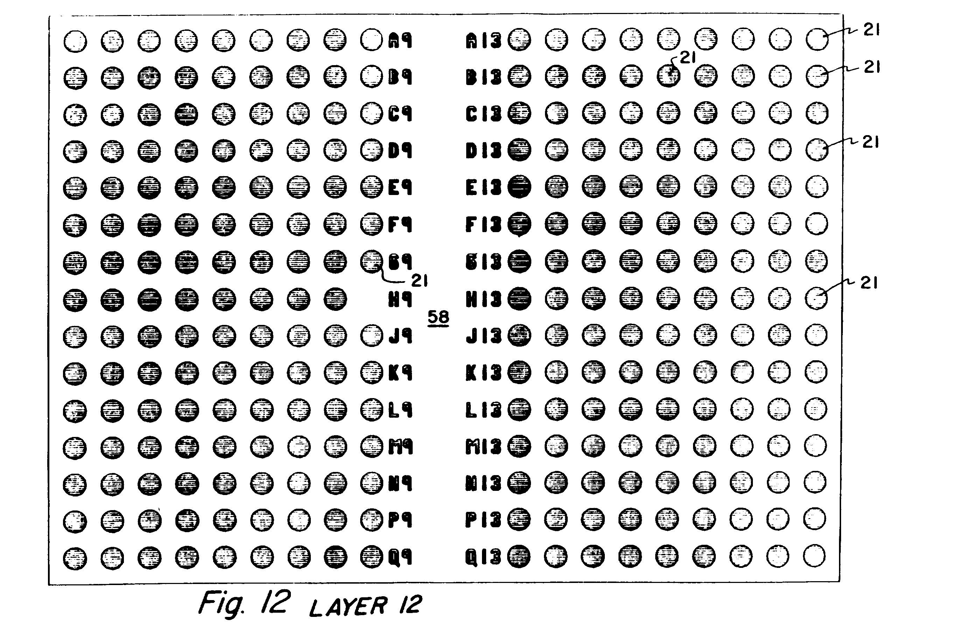

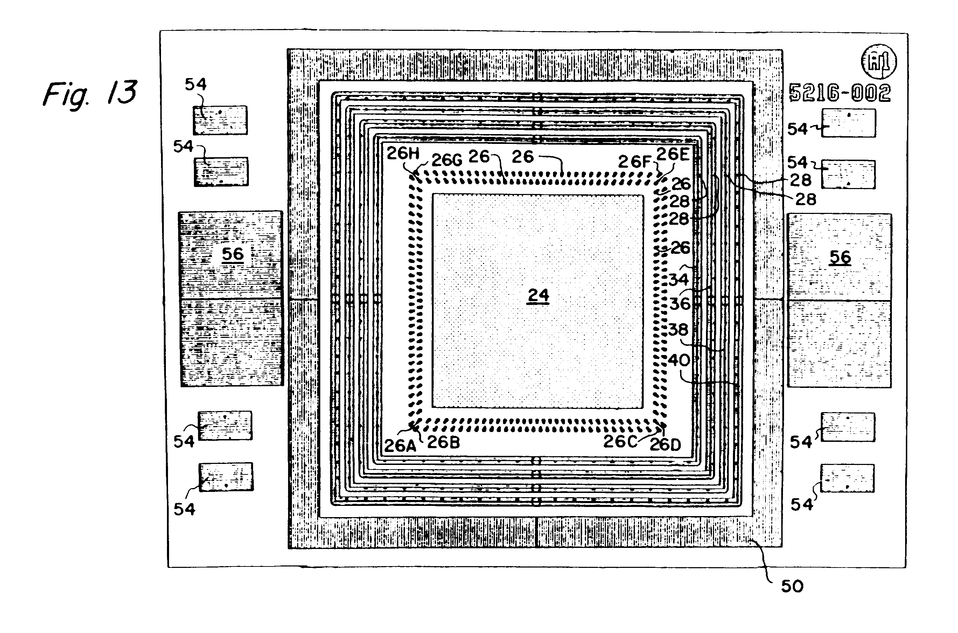

Details of the present invention are described with reference to Figures la and 4 to 13 where Figure 13 illustrates a top layer of the package and Figure 12 illustrates a bottom layer of the package, the bottom of the package containing in the embodiment illustrated 269 pads 21, to which are connected 269 pins 22 (Figure 1A) for use in connecting the package to another device such as to a next level of packaging, e.g., a printed circuit board.

Referring to Figures 1 and 1A, a semiconductor chip or die (not shown) containing signal, power or ground pads for connection to the present package is placed in die cavity 24. The signal, power, or ground pads of the chip are typically connected by wire bonds or by TAB connections to programmable pads 26 which surround die cavity 24 on layer 1 as shown (pads 26 are typically configure as bond pads but could also be configured as flip-chip or any other pads used for chip-to-package interconnect). There are 256 bond pads on layer 1 (Figure 1), and these 256 pads can be used as explained below for either power or ground; however, as also explained below, 248 of the pads on layer 1 (all but 8, 2 in each corner) can also be used for signals.

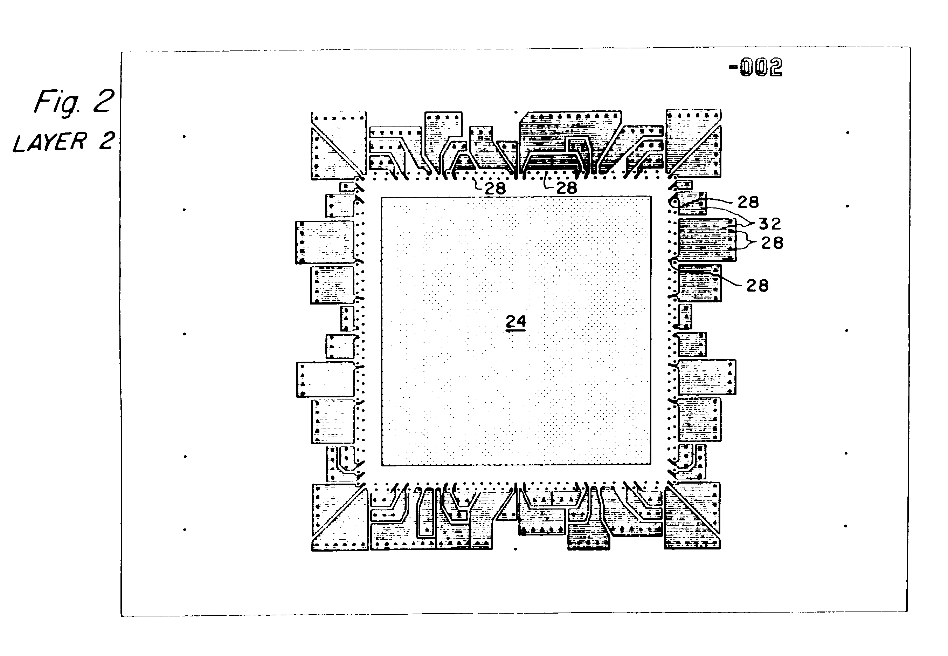

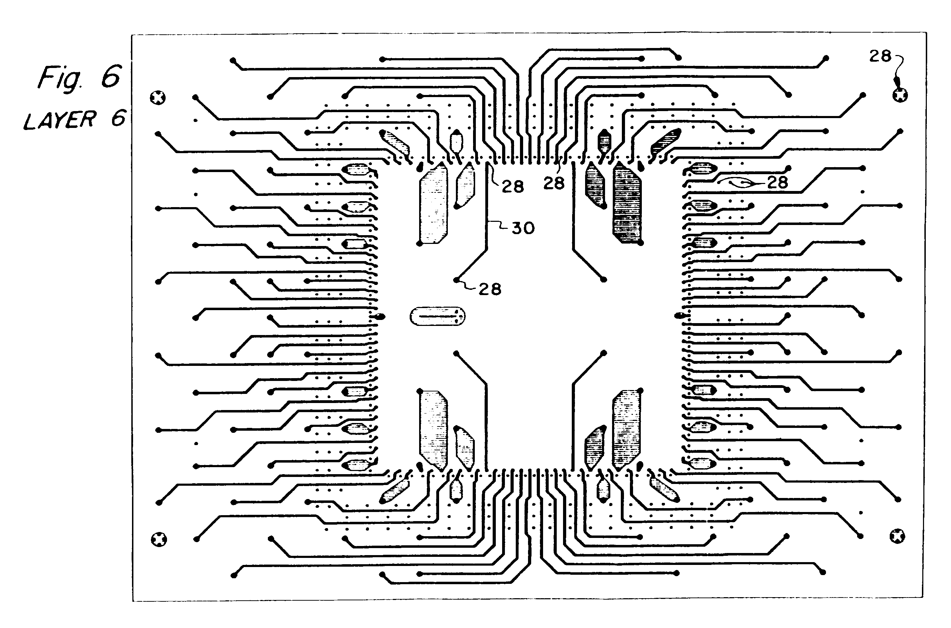

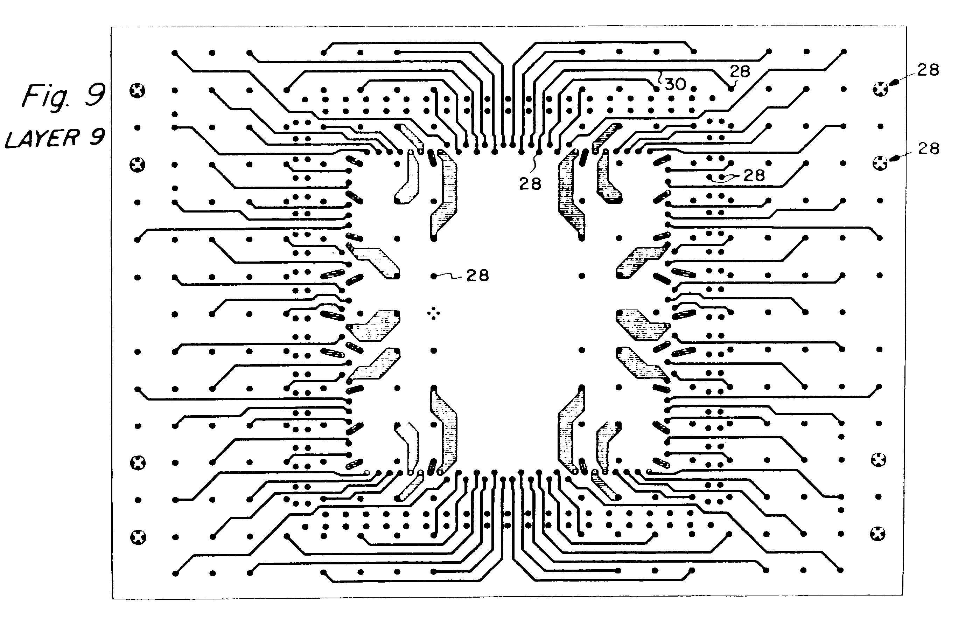

Accordingly, 248 of the 256 pads 26 shown in Figure 1 can be used for either signal, power, or ground. Whether the 248 pads will be used for signal, power, or ground is determined by how layer 2 (Figure 2) is configured, and this will be further explained below. The present package is preconfigured, however, so that all 248 pads which can be selectively used for either signal, power or ground are preconnected with signal leads to 248 corresponding pins or other connectors 22 (Figure 1A) located on an exterior surface of the package. In other words, all pads 26 shown on layer 1 except for two pads in each corner (pads 26A-26F) are preconnected with signal paths from layer 1 down through vias 28 to either layer 6 or layer 9 (see Figures 6 and 9), through leads 30 on layers 6 and 9, and then down through further vias 28 to 248 corresponding connectors 22 located on an exterior surface of the package.

This leaves 21 next-level-of-packaging connectors 22 which cannot be used for signals and which are dedicated to either power or ground. The manner in which power or ground is delivered to these dedicated connectors will be explained below.

The signal paths provided by the preconfigured connections from the 248 pads in layer 1 through signal leads 30 in layers 6 and 9 to the corresponding 248 connectors 22 have a typical resistance on the order of one ohm and an typical inductance on the order of two nanohenries/cm; such resistance and inductance values are normally acceptable for providing signals to and from the semiconductor chip and the next-level-of-packaging connectors 22. However, as previously mentioned, for providing power or ground from semiconductor chip pads to connectors 22, a relatively low resistance and inductance is desired; most chip package specifications require a resistance for these connections of less than 0.1 ohm, and an inductance value in the picohenry range is typically desirable. Accordingly, it is not adequate to provide power or ground connections between pads 26 on layer 1 and connectors 22 at the bottom or other surface of the chip package through signal leads 30 of layers 6 and 9.

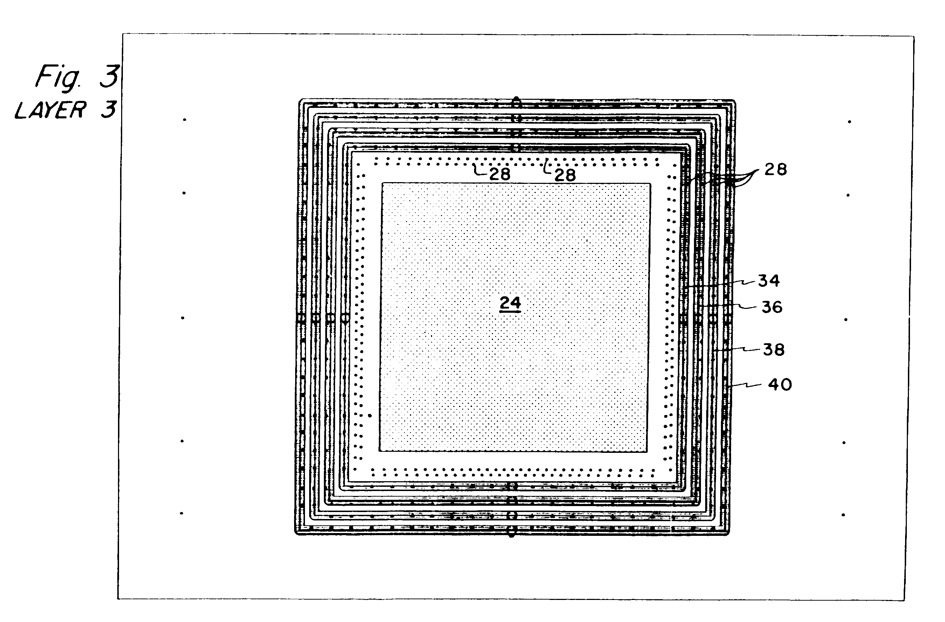

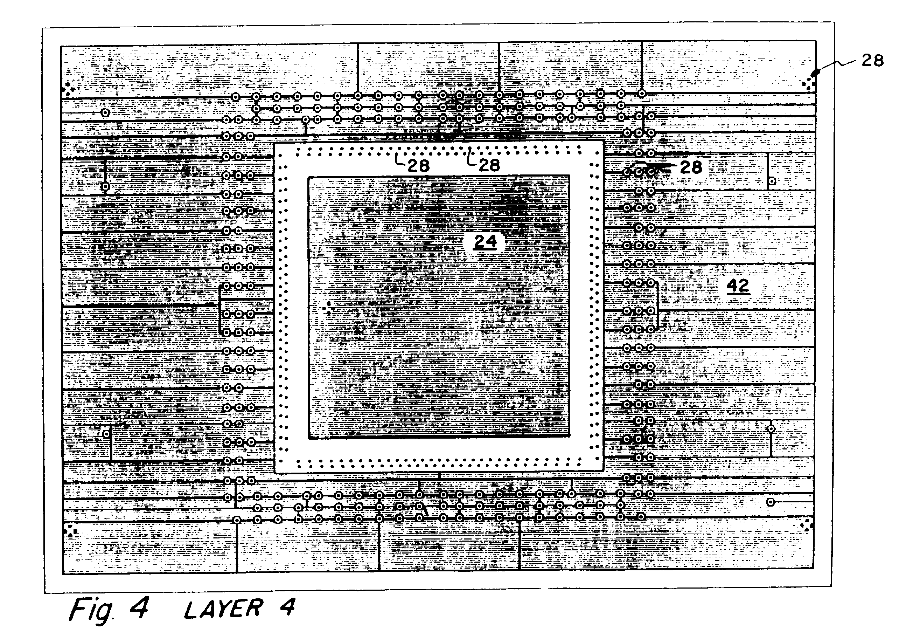

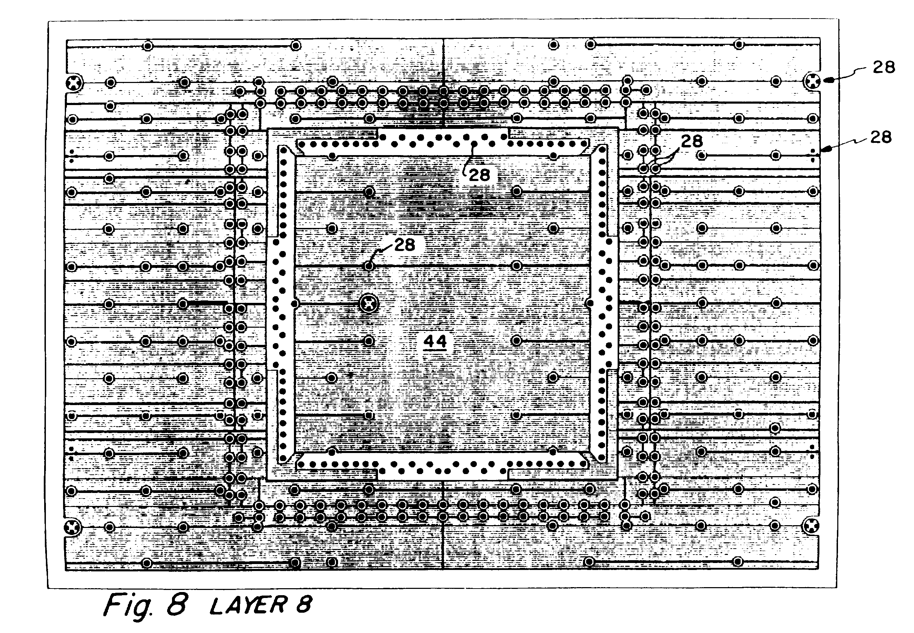

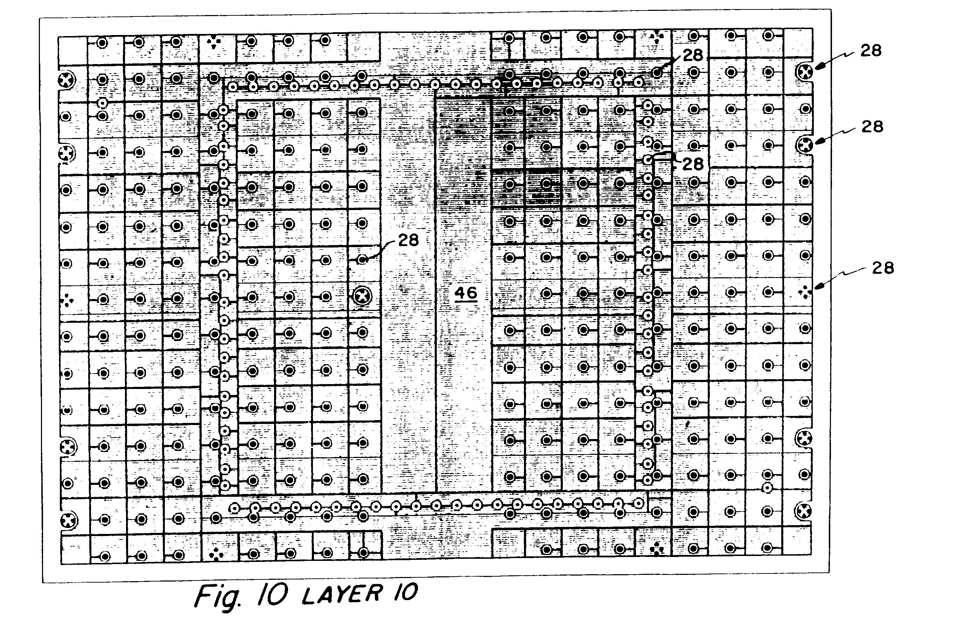

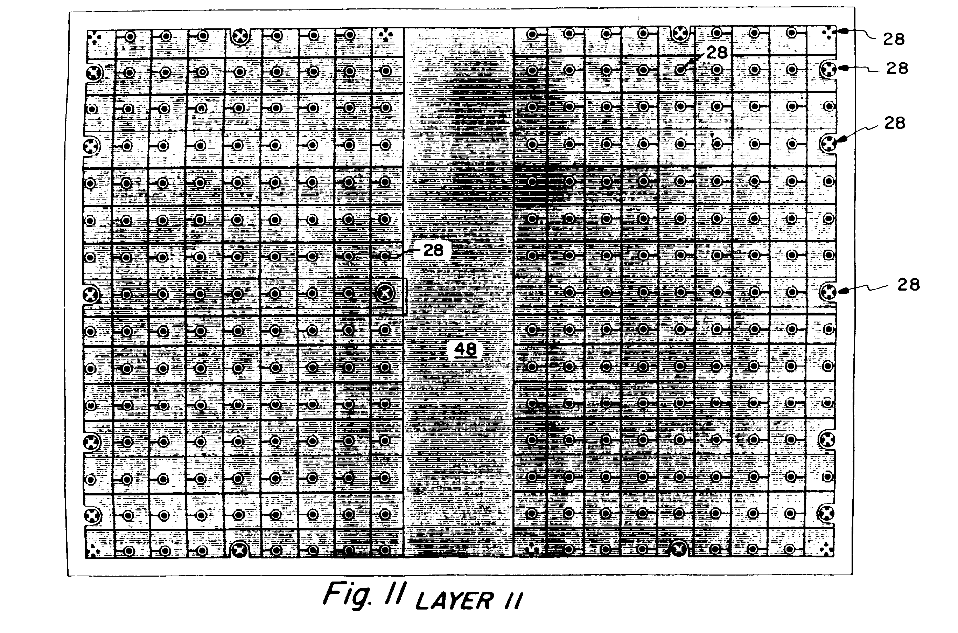

Achieving selectivity of the 248 programmable pads while at the same time meeting the low resistance and inductance path requirements for power and ground connections is implemented in one preferred embodiment through power and grounds pads 32 located in layer 2; (see Figure 2); thorough power and ground rings such as rings 34-40 located in layer 3 (see Figure 3); through four metal planes located in layers 4, 8, 10 and 11 (see Figures 4, 8, 10 and 11); through connector pins or other connectors 22 which are located at the bottom or other exterior surface of the chip package and which are dedicated to power or ground; and through vias 28 connecting these elements between layers. Significantly, only layer 2 (Figure 2) of the preferred embodiment needs to be modified in order to convert one of the 248 programmable pads 26 from being a signal pad to being a power or ground pad. The remainder of the package remains standard. This single layer change for complete customization has previously been unavailable in the prior art.

In the preferred embodiment, on-power or ground pad 32 is configured in layer 2 (Figure 2) for each pad 26 in layer 1 requiring a connection to power or ground. Each power or ground pad 32 in layer 2 is connected by a via 28 to a corresponding programmable pad 26 in layer 1 and by an additional via 28 (typically by several additional vias 28) to one of the four power or ground rings 34-40 below it in layer 3.

One each of these rings 34-40 in layer 3 is in turn connected by vias to one of four metal planes 42, 44, 46, or 48 contained in layers 4, 8, 10 and 11 (see Figures 4, 8, 10 and 11). These four metal planes are each connected to a portion of the dedicated power or ground connectors 22.

While less than four rings 34-40 and planes 42-48 could have been used (i.e., while some systems may require only a single power level and a single ground level), four rings and metal planes were designed into the present package in order to provide the ability to include two power levels for a semiconductor chip (e.g., to mix technologies such as CML and TTL requiring different voltages of, for example, 3.3 and 5.0 volts) as well as two ground levels.

Accordingly, using these elements of the preferred embodiment, delivery of either power or ground through any of the 248 programmable pads 26 in layer 1 to power or ground connectors 22 at the bottom of the chip package is accomplished by designing power or ground pads 32 on layer 2 to extend horizontally from a via connection 28 located below a selected programmable pad 26 in layer 1 over to a location in layer 2 above the respective ring desired in layer 3 and by dropping vias 28 from the power or bond pad 32 in layer 2 down to the selected ring in layer 3. In the preferred embodiment shown, this extension and via connection makes a path of least resistance and inductance from the programmable pad 26 selected on layer 1, down a via 28 from the pad on layer 1 to the configured power or ground pad 32 in layer 2, down through vias 28 to a selected power or ground ring 34, 36, 38 or 40 in layer 3, down through vias 28 from the selected power or ground ring in layer 3 to a corresponding metal plane 42, 44, 46 or 48 below, through the metal plane, and down through vias 28 to the corresponding dedicated power or ground pins 22 (via corresponding pads 21 shown in layer 12) at the bottom of the semiconductor chip package. Through use of the relatively large area power or ground pads 32 in layer 2 and the metal planes corresponding to the power or ground rings in layer 3, the desired path of relatively low resistance and inductance for power or ground is achieved.

Accordingly, in the embodiment illustrated, the only layer that must be separately tooled for each different semiconductor chip is layer 2 (Figure 2). The illustrative power or ground pads 32 shown in layer 2 total in number to 62; it can be seen that some of these pads are configured so that the vias connect to the innermost ring 34 in layer 3 and that other pads in layer 2 are selectively designed so that the vias extending below them connect to one of the other three rings in layer 3.

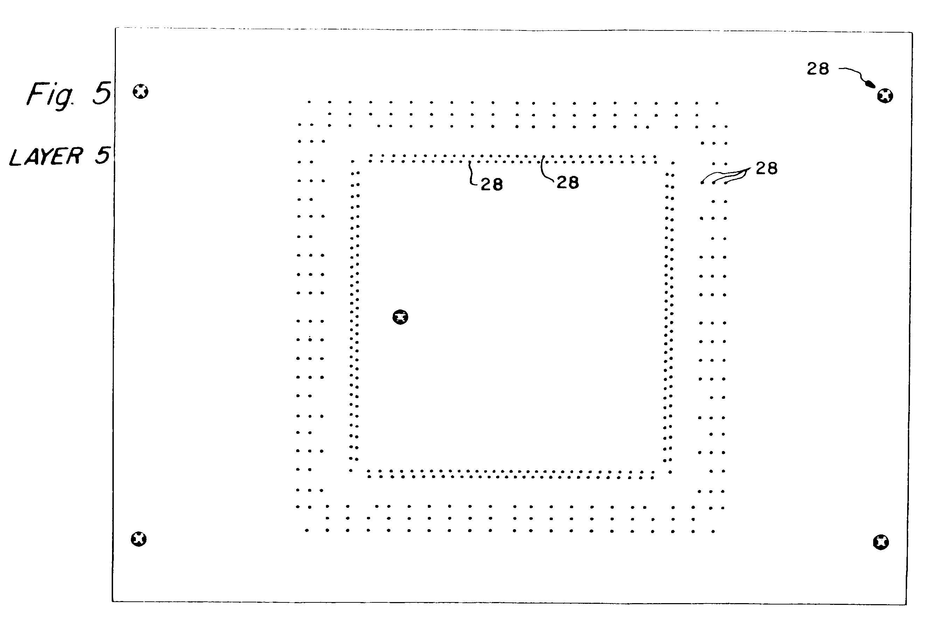

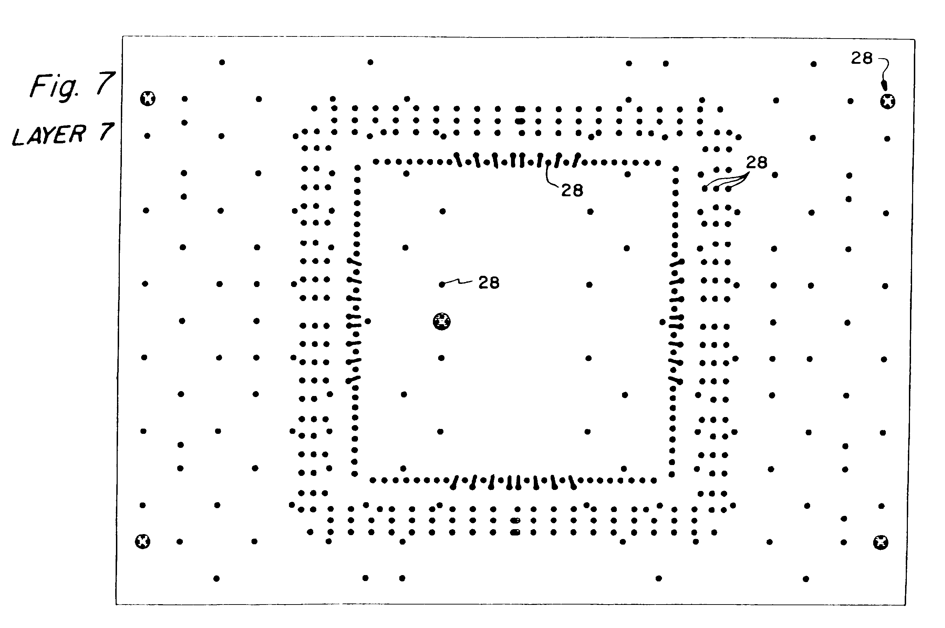

Layers 5 and 7 (Figures 5 and 7) serve primarily as spacers in the preferred embodiment to obtain appropriate spacing between metal layers. In both layers 5 and 7, vias 28 continuing down from upper layers can be seen and, in layer 7, some via fanout is shown for compatibility with the requirements of a particular vendor.

In the preferred embodiment as illustrated, the two pads in each corner of layer 1 (pads 26A-26G) are available only for power or ground. Each of these eight pads are connected to one of the four power or ground planes in layers 4, 8, 10 and 11 which, in turn, are each connected to a portion of the pins dedicated to power or ground. This approach to making these eight pins dedicated to power or ground would not have been necessary; however, it is frequently typical to have corner pads connected to power or ground.

In the preferred embodiment, the bottom of cavity 24 comprises a metal plane 24 (Figure 4), which is connected to a dedicated ground connector.

Many of the details shown in the design of the preferred embodiment are not necessary to the present invention. For example, pins 22 can be any type of connector compatible with an interfacing device, and connectors 22 can be located on any exterior surface desired. By way of another example, it would not have been necessary to use separate layers 1 and 2; in fact, in an alternate design, layers 1 and 2 are combined such that, in order to connect a layer 1 pad 26 to either power or ground, the pads 32 shown in layer 2 are instead simply configured onto layer 1, with vias 28 connecting each configured pad 32 with a selected ring below. The decision to use both layers 1 and 2 as shown was related primarily to cleaning up the appearance of the chip package; in the preferred embodiment, the variable configuration of the selectively configured power or ground pads 32 is hidden in layer 2. Either configuration will work equally well, however.

An additional variation of the present invention has importance. In this variation, the power and ground pads 32 of layer 2 are not used; instead, layer 2 is eliminated completely, and layers 1 and 3 are combined so that the top layer of the semiconductor chip package includes both the programmable pads 26 and rings 34, 36, 38 and 40. In this configuration, illustrated in Figure 13, chip pads to be connected to power or ground can be directly connected to a desired power or ground ring; alternatively, converting a programmable pad 26 to a power or ground connection requires only a direct connection between the appropriate ring and the programmable pad 26 which is to be converted to power or ground. These connections can be made by wire bonds or by any appropriate means. This variation of the present package requires an extra bond to be made for each programmable pad 26 selected for use with power or ground; however, it totally eliminates the requirement for package tooling, which is required in the preferred embodiment for configuring layer 2. Accordingly, this latter variation, in which layer 2 is eliminated and in which programmable pads 26 and rings 34-40 are both put on the top layer, is particularly well suited for proto-typing.

The drawings illustrate a variety of additional features of the preferred embodiments, including a site 50 on which to mount a seal ring 52 for attaching a cover. In addition, layer 1 in Figures 1 and 13 includes two large laser marking pads 56 and sites 54 for attaching capacitors for decoupling between planes. A central path 58 for heat removal is also shown on bottom layer 12 (Figure 12). In the preferred embodiment, each layer is electrically insulated from adjacent layers by ceramic layers, typically 0.38 mm in thickness, the corresponding features of each layer being interconnected for electrical conduction only by vias 28.

In applying the present invention, when programmable pads 26 are connected to dedicated power or ground connectors through the relatively low resistance, low impedance paths within the chip, each pad so connected also remains connected to it corresponding signal connector. The useful power or ground path then becomes the low resistance low inductance path to the power or ground connector; the corresponding signal connector and power or ground connector may also be tied together in order to ensure that both connectors are tied to the appropriate power or ground.

## Claims

1. A semiconductor chip package comprising:
a) a plurality of connector pads (26) located on a first surface of the package and arranged about the periphery of a semi-conductor chip (24), each pad being adapted for interconnection with the semiconductor chip;
b) a plurality of electrical connectors (22) located on a second surface of the package, some of the electrical connectors (22) being dedicated power or ground connectors (22) and others being signal connectors.
c) a plurality of signal connection means (28, 30) providing an electrically conductive path between an individual connector pad (26) and a corresponding individual signal connector (22); and
d) a plurality of electrical connection means (28, 32 to 48) comprising conductive paths for selectively connecting any connector pad (26) to one of the power or ground connectors; the electrical connection means comprising at least two large area conductor areas (32 to 40).
characterised in that:
e) at least two large area conductor areas (34 to 40) are ring-shaped, provided on or beneath the first surface and, in plan view, are arranged around the contour of the semiconductor chip (24) and surround the connector pads (26).

2. A package according to claim 1, in which the large area ring-shaped conductor areas (34 to 40) are provided beneath the first surface of the package, and the electrical connection means comprises a plurality of power or ground pads (32) located in a single layer (2) between the ring-shaped conductor areas and the first surface, the pads (32) are arranged to extend radially outwards parallel to the plane of the layer in which they are located, whereby the shape of the pads 32 determines which connector pad 26 is selected for connection to which ring-shaped conductor area.

3. A package according to claim 1, in which the large area ring-shaped conductor areas (34 to 40) are provided on the first surface and selected ones of said chip pads are adapted for being connected to one of said large area ring-shaped conductor areas (34 to 40) and other chip pads are adapted for being connected to one of said connector pads (26).

4. A semiconductor chip package according to claim 1, 2 or 3 in which the signal connecting means and/or the electrical connection means comprise vias (28) extending through a layer of insulating material in a direction perpendicular to the plane of the layer.

5. A semiconductor chip package according to any preceding claim, in which the package comprises a plurality of layers and in which the electrical connection means comprises one or more connection means (30 to 48) extending parallel to the plane of the layer.

6. A package according to claim 5, in which the electrical connection means comprises some of the vias (28) interconnecting selected connector pads (26) with the connection means (30 to 48) extending parallel to the plane of the layer.

7. A package according to any preceding claim, in which the electrical connection means (30 to 48) comprises at least one first intermediate layer (4,8) which consists of a first metal plane (42, 44) and at least one second intermediate layer (10, 11) which consists of a second metal plane (46, 48), with said first metal plane (42, 44) adapted for being connected to a power source and said second metal plane (46, 48) adapted for ground connection.

8. A package according to claim 7 in which each of the ring-shaped large area conductor areas (32 to 40) is electrically connected to one of the metal planes (42 to 48) respectively by one of a first group of vias.

9. A chip package according to any preceding claim, characterised in that:
g) the electrical connection means comprises at least one layer (6, 9) comprising a plurality of individual signal leads (30) extending parallel to the plane of the layer (6, 9);
h) some of the signal leads (30) are connected by one via of a second group of vias (28) to one of the connector pads (26); and
i) others of said signal leads (30) are connected by one via (28) of a third group of vias to one of said electrical connectors (22).

10. A chip package of any preceding claim, characterised in that there is provided
j) first, second, third, and fourth area ring-shaped conductor areas (34 to 40) and
k) first, second, third, and fourth metal planes (42 to 48)
l) each ring-shaped conductor area is electrically connected to a respective metal plane by at least one metal plane via (28) and
m) each individual dedicated ground or power connector (22) is electrically connected to one of the metal planes (42 to 48) by at least one power or ground connector vias (28).

## Patentansprüche

1. Halbleiterchipbaustein mit folgendem :
a) einer Mehrzahl von auf einer ersten Oberfläche des Bausteins befindlichen Anschlußkontaktstellen (26), die um den Umfang eines Halbleiterchips (24) herum angeordnet sind, wobei jede Kontaktstelle zur Verbindung mit dem Halbleiterchip geeignet ist;
b) einer Mehrzahl von auf einer zweiten Oberfläche des Bausteins befindlichen elektrischen Verbindern (22), von denen einige fest zugeordnete Strom- oder Erdverbinder (22) und andere Signalverbinder sind.
c) einer Mehrzahl von Signalverbindungsmitteln (28, 30), die einen elektrisch leitenden Weg zwischen einer einzelnen Anschlußkontaktstelle (26) und einem entsprechenden einzelnen Signalverbinder (22) bereitstellen; und
d) einer Mehrzahl von elektrischen Verbindungsmitteln (28, 32 bis 48) mit leitenden Wegen zur gezielten Verbindung einer beliebigen Anschlußkontaktstelle (26) mit einem der Strom- oder Erdverbinder; wobei die elektrischen Verbindungsmittel mindestens zwei großflächige Leiterbereiche (32 bis 40) umfassen,
dadurch gekennzeichnet, daß:
e) mindestens zwei großflächige Leiterbereiche (34 bis 40) ringförmig, auf oder unterhalb der ersten Oberfläche vorgesehen und in Draufsicht um den Umriß des Halbleiterchips (24) herum angeordnet sind und die Anschlußkontaktstellen (26) umgeben.

2. Baustein nach Anspruch 1, bei dem die großflächigen ringförmigen Leiterbereiche (34 bis 40) unterhalb der ersten Oberfläche des Bausteins vorgesehen sind und die elektrischen Verbindungsmittel eine Mehrzahl von Strom- oder Erdkontaktstellen (32) umfassen, die sich in einer einzigen Schicht (2) zwischen den ringförmigen Leiterbereichen und der ersten Oberfläche befinden, wobei die Kontaktstellen (32) so angeordnet sind, daß sie sich radial nach außen parallel zur Ebene der Schicht, in der sie sich befinden, erstrecken, wodurch die Form der Kontaktstellen 32 bestimmt, welche Anschlußkontaktstelle 26 zur Verbindung mit welchem ringförmigen Leiterbereich ausgewählt wird.

3. Baustein nach Anspruch 1, bei dem die großflächigen ringförmigen Leiterbereiche (34 bis 40) auf der ersten Oberfläche vorgesehen sind und ausgewählte der besagten Chipkontaktstellen dazu geeignet sind, mit einem der besagten großflächigen ringförmigen Leiterbereiche (34 bis 40) verbunden zu werden, und andere Chipkontaktstellen dazu geeignet sind, mit einer der besagten Anschlußkontaktstellen (26) verbunden zu werden.

4. Halbleiterchipbaustein nach Anspruch 1, 2 oder 3, bei dem die Signalverbindungsmittel und/oder die elektrischen Verbindungsmittel sich durch eine Schicht von Isoliermaterial in einer Richtung senkrecht zur Ebene der Schicht erstreckende Kontaktlöcher (28) umfassen.

5. Halbleiterchipbaustein nach einem der vorhergehenden Ansprüche, bei dem der Baustein eine Mehrzahl von Schichten umfaßt und bei dem die elektrischen Verbindungsmittel ein oder mehrere sich parallel zur Ebene der Schicht erstreckende Verbindungsmittel (30 bis 48) umfassen.

6. Baustein nach Anspruch 5, bei dem die elektrischen Verbindungsmittel einige der Kontaktlöcher (28) umfassen, die ausgewählte Anschlußkontaktstellen (26) mit den sich parallel zur Ebene der Schicht erstreckenden Verbindungsmitteln (30 bis 48) verbinden.

7. Baustein nach einem der vorhergehenden Ansprüche, bei dem die elektrischen Verbindungsmittel (30 bis 48) mindestens eine erste Zwischenschicht (4, 8), die aus einer ersten Metallebene (42, 44) besteht, und mindestens eine zweite Zwischenschicht (10, 11), die aus einer zweiten Metallebene (46, 48) besteht, umfassen, wobei die besagte erste Metallebene (42, 44) dafür geeignet ist, mit einer Stromquelle verbunden zu werden, und die besagte zweite Metallebene (46, 48) zur Erdverbindung geeignet ist.

8. Baustein nach Anspruch 7, bei dem jeder der ringförmigen großflächigen Leiterbereiche (32 bis 40) elektrisch durch eines einer ersten Gruppe von Kontaktlöchern mit jeweils einer der Metallebenen (42 bis 48) verbunden ist.

9. Chipbaustein nach einem der vorhergehenden Ansprüche, dadurch gekennzeichnet, daß:
g) die elektrischen Verbindungsmittel mindestens eine Schicht (6, 9) mit einer Mehrzahl von einzelnen sich parallel zur Ebene der Schicht (6, 9) erstreckenden Signalleitungen (30) umfassen;
h) einige der Signalleitungen (30) über ein Kontaktloch einer zweiten Gruppe von Kontaktlöchern (28) mit einer der Anschlußkontaktstellen (26) verbunden sind; und
i) andere der besagten Signalleitungen (30) über ein Kontaktloch (28) einer dritten Gruppe von Kontaktlöchern mit einem der besagten elektrischen Verbinder (22) verbunden sind.

10. Chipbaustein nach einem der vorhergehenden Ansprüche, dadurch gekennzeichnet, daß folgendes vorgesehen ist:
j) erste, zweite, dritte und vierte großflächige ringförmige Leiterbereiche (34 bis 40) und
k) erste, zweite, dritte und vierte Metallebenen (42 bis 48)
l) jeder ringförmige Leiterbereich elektrisch über mindestens ein Metallebenenkontaktloch (28) mit einer entsprechenden Metallebene verbunden ist und
m) jeder einzelne fest zugeordnete Erd- oder Stromverbinder (22) elektrisch durch mindestens ein Strom- oder Erdverbinderkontaktloch (28) mit einer der Metallebenen (42 bis 48) verbunden ist.

## Revendications

1. Empaquetage pour puce semi-conductrice comprenant:
a) une pluralité de plages de connexion (26) situées sur une première surface de l'empaquetage et disposées autour de la périphérie d'une puce semi-conductrice (24), chaque plage étant adaptée en vue de son interconnexion avec la puce semi-conductrice;
b) une pluralité de connecteurs électriques (22) situés sur une deuxième surface de l'empaquetage, certains des connecteurs électriques (22) étant des connecteurs de puissance ou de masse dédiés (22) et d'autres étant des connecteurs de signaux.
c) une pluralité de moyens de connexion de signaux (28, 30) fournissant un chemin électriquement conducteur entre une plage de connexion individuelle (26) et un connecteur de signal individuel correspondant (22); et
d) une pluralité de moyens de connexion électriques (28, 32 à 48) comprenant des chemins conducteurs pour connecter sélectivement n'importe quelle plage de connexion (26) à l'un des connecteurs de puissance ou de masse; le moyen de connexion électrique comprenant au moins deux zones de conduction de grande surface (32 à 40).
caractérisé en ce que:
e) au moins deux zones de conduction de grande surface (34 à 40) sont de forme annulaire, fournies sur ou en dessous de la première surface et, en vue en plan, sont disposées autour du contour de la puce semi-conductrice (24) et entourent les plages de connexion (26).

2. Empaquetage selon la revendication 1, dans lequel les zones conductrices de forme annulaire de grande surface (34 à 40) sont fournies en dessous de la première surface de l'empaquetage, et le moyen de connexion électrique comprend une pluralité de plages de puissance ou de masse (32) situées dans une couche unique (2) entre les zones de conduction de forme annulaire et la première surface, les plages (32) sont disposées pour s'étendre radialement vers l'extérieur parallèlement au plan de la couche dans laquelle elles sont situées, de telle sorte que la forme des plages 32 détermine la plage de connexion 26 qui est sélectionnée pour la connexion avec une zone de conduction de forme annulaire particulière.

3. Empaquetage selon la revendication 1, dans lequel les zones conductrices de forme annulaire de grande surface (34 à 40) sont fournies sur la première surface et des plages sélectionnées desdites plages de puce sont adaptées pour être connectées à l'une desdites zones conductrices de forme annulaire de grande surface (34 à 40) et d'autres plages de puce sont adaptées pour être connectées à l'une desdites plages de connexion (26).

4. Empaquetage pour puce semi-conductrice selon la revendication 1, 2 ou 3, dans lequel les moyens de connexion de signaux et/ou les moyens de connexion électriques comprennent des vias (28) s'étendant à travers une couche de matière isolante dans une direction perpendiculaire au plan de la couche.

5. Empaquetage pour puce semi-conductrice selon n'importe quelle revendication précédente, dans lequel l'empaquetage comprend une pluralité de couches et dans lequel le moyen de connexion électrique comprend un ou plusieurs moyens de connexion (30 à 48) s'étendant parallèlement au plan de la couche.

6. Empaquetage selon la revendication 5, dans lequel le moyen de connexion électrique comprend certaines des vias (28) interconnectant des plages de connexion sélectionnées (26) avec les moyens de connexion (30 à 48) s'étendant parallèlement au plan de la couche.

7. Empaquetage selon n'importe quelle revendication précédente, dans lequel le moyen de connexion électrique (30 à 48) comprend au moins une première couche intermédiaire (4,8) qui consiste en un premier plan métallique (42, 44) et au moins une deuxième couche intermédiaire (10, 11) qui consiste en un deuxième plan métallique (46, 48), ledit premier plan métallique (42, 44) étant adapté pour être connecté à une source de puissance et ledit deuxième plan métallique (46, 48) étant adapté pour la connexion à la masse.

8. Empaquetage selon la revendication 7, dans lequel chacune des zones conductrices de grande surface de forme annulaire (32 à 40) est connectée électriquement à l'un des plans métalliques (42 à 48) respectivement par un d'un premier groupe de vias.

9. Empaquetage pour puce selon n'importe quelle revendication précédente, caractérisé en ce que:
g) le moyen de connexion électrique comprend au moins une couche (6, 9) comprenant une pluralité de conducteurs de signaux individuels (30) s'étendant parallèlement au plan de la couche (6, 9);
h) certains des conducteurs de signaux (30) sont connectés par une via d'un deuxième groupe de vias (28) à l'une des plages de connexion (26); et
i) d'autres desdits conducteurs de signaux (30) sont connectés par une via (28) d'un troisième groupe de vias à l'un desdits connecteurs électriques (22).

10. Empaquetage pour puce selon n'importe quelle revendication précédente, caractérisé en ce que sont fournis
j) des première, deuxième, troisième et quatrième zones de conduction de forme annulaire (34 à 40) et
k) des premier, deuxième, troisième et quatrième plans métalliques (42 à 48)
l) chaque zone conductrice de forme annulaire est connectée électriquement à un plan métallique respectif par au moins une via de plan métallique (28) et
m) chaque connecteur de masse ou de puissance dédié individuel (22) est connecté électriquement à l'un des plans métalliques (42 à 48) par au moins une via de connexion de puissance ou de masse (28).
